# EUROPÄISCHE PATENTANMELDUNG

(11) **EP 2 014 520 A1**
(43) Veröffentlichungstag der Anmeldung: **14.01.2009**
(21) Anmeldenummer: 08464003.6
(22) Anmeldetag: 11.02.2008
(51) Int. Cl.: B60R 21/01, A44B 17/00, F16B 5/06, F16B 21/00, G01C 9/00, G01P 15/02, G01S 13/00, H05K 5/00

(54) **Elektrisches Gerät für ein Kraftfahrzeug, insbesondere Airbag-Sensor**

(71) Anmelder: Continental Automotive GmbH, 30165 Hannover (DE)
(72) Erfinder: Goron, Gabriel, 400335 Cluj - Napoca (RO)

(57) **Zusammenfassung**

Die Erfindung betrifft ein elektrisches Gerät (1) für ein Kraftfahrzeug, insbesondere einen Airbag-Sensor, mit einem Gehäuse (2) zur Aufnahme eines Sensors und mit einem Befestigungsmittel zur Befestigung des Geräts (1) an einer Anbaufläche (4) des Kraftfahrzeugs. Das Befestigungsmittel umfasst einen Befestigungsstreifen (3), der teilweise in das Gehäuse (2) des elektrischen Geräts (1) eingelassen und mit seinen gegenüberliegenden Enden (5, 6) mit korrespondierenden Aussparungen (7, 8) der Anbaufläche (4) des Kraftfahrzeugs formschlüssig verbunden ist.

## Beschreibung

Die Erfindung betrifft ein elektrisches Gerät für ein Kraftfahrzeug, insbesondere einen Airbag-Sensor, mit einem Gehäuse zur Aufnahme eines Sensors und mit einem Befestigungsmittel zur Befestigung des Geräts an einer Anbaufläche des Kraftfahrzeugs.

Insbesondere bei Geräten für sicherheitsrelevante oder fahrdynamische Systeme in einem Kraftfahrzeug, wie z.B. Satelliten-Sensoren, ist die zuverlässige, feste Anbindung des Geräts an die Anbaufläche des Kraftfahrzeugs von großer Bedeutung. Als Anbaufläche wird in der Regel ein aus Metall bestehendes Karosseriebauteil des Kraftfahrzeugs verwendet. Je nach Anordnung des Geräts kann diese Anbaufläche sich z.B. in der Front, an einem Mitteltunnel, an den Vorder- oder Hecktüren oder dem Heck des Kraftfahrzeugs befinden. Neben der spielfreien Befestigung in allen Bewegungsrichtungen ist darüber hinaus die einfache Montage des Geräts an der Anbaufläche von wesentlicher Bedeutung. Insbesondere soll die Montage mit einer einzigen Hand bewerkstelligt werden können, da der zur Verfügung stehende Montageraum häufig begrenzt ist.

Um diesen beiden Erfordernissen Rechnung zu tragen, wird bei bisherigen elektronischen Geräten die Befestigung mittels einer Schraube und einer Mutter vorgenommen. Hierzu ist ein Schraubbolzen an der Anbaufläche des Kraftfahrzeuges fixiert. Das Gerät, das an einem Gehäuseflansch eine Bohrung aufweist, wird auf den Schraubbolzen aufgesteckt und mit der Mutter fixiert. Nachteilig an dieser Befestigungsmethode ist der Umstand, dass beim Aufstecken des Geräts auf den Schraubbolzen ein Verkanten möglich ist. Ferner muss die Mutter blind auf den Schraubbolzen aufgeschraubt werden, wobei es ebenfalls zu Verkantungen kommen kann.

Es ist daher Aufgabe der vorliegenden Erfindung, ein elektrisches Gerät für ein Kraftfahrzeug, insbesondere einen Airbag-Sensor, zu schaffen, welcher mit einer Hand auf einfachere Weise an der Anbaufläche des Kraftfahrzeugs fixiert werden kann.

Diese Aufgabe wird durch ein elektrisches Gerät mit den Merkmalen des Patentanspruches 1 gelöst. Vorteilhafte Ausgestaltungen ergeben sich aus den abhängigen Patentansprüchen.

Die Erfindung schafft ein elektrisches Gerät für ein Kraftfahrzeug, insbesondere einen Airbag-Sensor, mit einem Gehäuse zur Aufnahme eines Sensors und mit einem Befestigungsmittel zur Befestigung des Geräts an einer Anbaufläche des Kraftfahrzeugs, bei dem das Befestigungsmittel einen Befestigungsstreifen umfasst, der teilweise in das Gehäuse des elektrischen Geräts eingelassen und mit seinen gegenüberliegenden Enden mit korrespondierenden Aussparungen der Anbaufläche des Kraftfahrzeugs formschlüssig verbunden ist.

Ein erfindungsgemäßes elektrisches Gerät lässt sich hierdurch unter Verzicht auf eine Schraubverbindung oder eine Nietung auf einfachere und sichere Weise an der Anbaufläche des Kraftfahrzeugs befestigen. Darüber hinaus weist das erfindungsgemäße elektrische Gerät den Vorteil auf, dass dieses auf einfache und kostengünstige Weise herstellbar ist. Ferner ist der für die erfindungsgemäße Befestigung notwenige Platzbedarf im Vergleich zu einem elektrischen Gerät aus dem Stand der Technik geringer. Weitere Kosten können dadurch eingespart werden, dass das Vorsehen z.B. eines Schraubbolzens an der Anbaufläche des Kraftfahrzeugs nicht notwendig ist. Gegenüber einer Schraubverbindung besteht darüber hinaus der Vorteil, dass die Montage des elektrischen Geräts auf schnellere Weise durchgeführt werden kann.

Bei dem erfindungsgemäßen elektrischen Gerät ist das Gehäuse zweckmäßigerweise aus einem Kunststoff gebildet. Hierdurch lässt sich das Gehäuse auf einfache und kostengünstige Weise herstellen. Um eine sichere Befestigung des elektrischen Geräts an der Anbaufläche sicherzustellen, ist der Befestigungsstreifen insbesondere aus einem Metall gebildet.

Die Fixierung des Befestigungsstreifens an dem Gehäuse erfolgt, wie gesagt, durch Einlassen in das Gehäuse, wobei z.B. der Befestigungsstreifen von dem Gehäusematerial umspritzt ist. Der Befestigungsstreifen kann hierbei mit Ausnahme der mit der Anbaufläche zu befestigenden Enden vollständig in das Gehäuse des elektrischen Geräts eingelassen sein. Der Befestigungsstreifen kann in dem Bereich, in dem er mit Gehäusematerial umhüllt ist, gerade oder gebogen ausgebildet sein, um die gewünschte starre Verbindung zu dem Gehäuse zu bewirken. Alternativ oder zusätzlich kann der Befestigungsstreifen auch mit dem Gehäuse auf andere Weise, z.B. mittels einer Schraube, verbunden sein.

Der Verzicht auf zusätzliche Befestigungsmaterialien und - mittel ergibt sich dadurch, dass die Befestigung des erfindungsgemäßen Geräts allein durch die Form des Befestigungsstreifens bewirkbar ist. Der Befestigungsstreifen kann hierzu mehrfach gebogen sein, so dass die Enden des Befestigungsstreifens mit den korrespondierenden Aussparungen der Anbaufläche formschlüssig verbindbar sind.

Gemäß einer weiteren zweckmäßigen Ausgestaltung weist der Befestigungsstreifen Abschnitte unterschiedlicher Elastizität auf. Hierdurch wird im Bereich der formschlüssigen Verbindung der Enden des Befestigungsstreifens mit den korrespondierenden Aussparungen eine Spannung bzw. Kraft erzeugt, welche die Fixierung des elektrischen Geräts an der Anbaufläche bewirkt. Hierdurch ist das elektrische Gerät spielfrei an der Anbaufläche befestigt.

Um eine gewünschte, vorgegebene Elastizität und/oder Form des Befestigungsstreifens bereitstellen zu können, kann der Befestigungsstreifen zumindest teilweise Einschnürungen oder Materialschwächungen aufweisen. Alternativ oder zusätzlich kann der Befestigungsstreifen zumindest teilweise Materialverdickungen aufweisen. Solche können insbesondere in dem Bereich von Vorteil sein, in dem der Befestigungsstreifen von Gehäusematerial umhüllt ist.

Der Formschluss mit der Anbaufläche kann gemäß einer weiteren Ausführungsform über zwei Schnappverbindungen herstellbar sein. Alternativ kann der Formschluss mit der Anbaufläche über eine Schnappverbindung und ein Scharnier herstellbar sein. In beiden Fällen ist gewährleistet, dass einerseits die Montage des elektrischen Geräts an der Anbaufläche einhändig und auf einfache Weise erfolgen kann. Andererseits ist ebenso die Entfernung des elektrischen Geräts von der Anbaufläche durch einfache Betätigung der jeweiligen Schnappverbindung möglich.

In einer besonders bevorzugten Ausgestaltung weist der Befestigungsstreifen an einem ersten Ende eine gebogene Befestigungslasche auf, die dazu geeignet ist, durch eine korrespondierende erste Aussparung der Anbaufläche geführt zu werden, wenn das elektrische Gerät auf die Anbaufläche aufgebracht ist, so dass ein Teil der Befestigungslasche auf einer dem Gehäuse gegenüberliegenden Seite der Anbaufläche und ein anderer Teil auf der Seite des Gehäuses der Anbaufläche angeordnet ist. Das erste Ende des Befestigungsstreifens dient damit lediglich zur starren Fixierung an der Anbaufläche.

In einer weiteren Ausbildung ist der Befestigungsstreifen an einem zweiten Ende dazu ausgebildet, mit einem Mittelabschnitt durch eine korrespondierende zweite Aussparung der Anbaufläche geführt zu werden, wenn das elektrische Gerät auf die Anbaufläche aufgebracht ist, so dass der Mittelabschnitt auf einer dem Gehäuse gegenüberliegenden Seite der Anbaufläche angeordnet und formschlüssig mit der Anbaufläche verbunden ist. An dem zweiten Ende wird die Schnappverbindung bereitgestellt, über welche die sichere Fixierung des elektrischen Geräts an der Anbaufläche sowie das Lösen des elektrischen Geräts von der Anbaufläche bewirkt werden.

Insbesondere weist der Mittelabschnitt in einer Erstreckungsrichtung eine größere Breite als die zweite Aussparung der Anbaufläche auf, wenn der Mittelabschnitt nicht mit Kraft beaufschlagt ist. Hierdurch wird die sichere Fixierung im Bereich der Schnappverbindung realisiert. Das Durchführen des Mittelabschnitts durch die zweite Aussparung wird dadurch ermöglicht, dass der Mittelabschnitt unter Kraftaufbringung reversibel deformierbar ausgebildet ist.

Weiterhin ist das zweite Ende derart ausgebildet, dass ein Endabschnitt des zweiten Endes des Befestigungsstreifens von der Seite des Gehäuses her betätigbar ist, wenn das elektrische Gerät auf die Anbaufläche aufgebracht ist oder wird. Hierdurch wird das spätere Entfernen des elektrischen Geräts von der Anbaufläche ermöglicht.

Als Codierung für die Montage des korrekten elektrischen Geräts und weitere Verbesserung der Fixierung ist ferner vorgesehen, dass das Gehäuse zumindest einen Vorsprung aufweist, welcher in eine dritte Aussparung der Anbaufläche ragt, wenn das elektrische Gerät auf die Anbaufläche aufgebracht ist.

In einer weiteren konkreten Ausgestaltung ist der Sensor ein Crash-Sensor, insbesondere ein Beschleunigungssensor, ein Körperschallsensor oder ein Drucksensor.

Die Erfindung wird nachfolgend näher anhand eines Ausführungsbeispiels in der Zeichnung beschrieben.

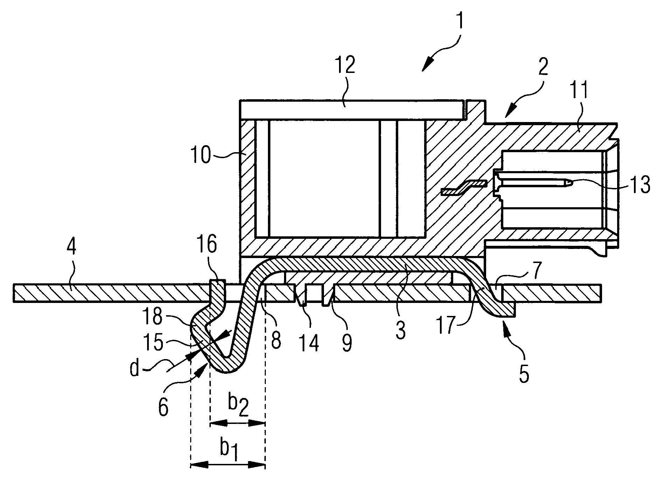

- Figur 1: zeigt in einer Querschnittsdarstellung ein an einer Anbaufläche eines Kraftfahrzeugs fixiertes erfindungsgemäßes elektrisches Gerätes.

Ein Gehäuse 2 eines erfindungsgemäßen elektrischen Gerätes 1 umfasst in bekannter Weise einen Gehäusegrundkörper 10 mit einem Innenraum zur Aufnahme einer elektronischen Schaltung. Die elektronische Schaltung umfasst insbesondere einen Crash-Sensor, wie z.B. einen Beschleunigungssensor, einen Körperschallsensor oder einen Drucksensor, um die Kollision eines Kraftfahrzeugs, in dem das Gerät 1 verbaut ist, mit einem anderen Objekt zu detektieren. Die in der Figur nicht dargestellte elektronische Schaltung ist über Kontaktstifte 13, welche in eine mit dem Gehäusegrundkörper 10 verbundene Kammer 11 ragen, extern kontaktierbar. Zum Schutz der elektronischen Schaltung vor Umgebungseinflüssen ist auf dem Gehäusegrundkörper 10 ein Deckel 12 aufgebracht, welcher den Innenraum mit den elektronischen Elementen hermetisch verschließt. Hierbei kann zwischen dem Gehäusegrundkörper 10 und dem Deckel 12 eine Dichtung (nicht dargestellt) vorgesehen sein. Die Ausgestaltung der elektronischen Schaltung sowie des Gehäusegrundkörpers ist für die Erfindung nicht von primärer Bedeutung, so dass auf eine nähere Beschreibung verzichtet wird.

Die Befestigung des Gehäuses 2 an einer Anbaufläche 4 des Kraftfahrzeugs erfolgt über einen aus Metall bestehenden Befestigungsstreifen 3. Die Anbaufläche kann durch ein beliebiges Karosseriebauteil des Kraftfahrzeugs gebildet sein. Sie besteht vorzugsweise aus Metall. Bei der Anbaufläche des Kraftfahrzeugs kann es sich beispielsweise um ein tragendes Karosseriebauteil an der Front oder dem Heck, eine Vorder-oder Hintertür oder den Fahrzeugtunnel handeln.

Der Befestigungsstreifen 3 ist teilweise in das Gehäuse 2 des elektrischen Geräts eingelassen. Mit seinen gegenüberliegenden Enden - einem ersten Ende 5 und einem zweiten Ende 6 - ist der Befestigungsstreifen 3 mit korrespondierenden Aussparungen 7, 8 der Anbaufläche 4 des Kraftfahrzeugs formschlüssig verbunden. Der Befestigungsstreifen kann in dem zwischen dem ersten und dem zweiten Ende 5, 6 liegenden Abschnitt vollständig von Gehäusematerial des Gehäuses 2 umgeben sein. Ist das Gehäuse 2, wie in einer bevorzugten Ausgestaltung vorgesehen, aus einem Kunststoff gebildet, so kann der Befestigungsstreifen 3 durch Umspritzen in das Gehäuse eingelassen werden. Hierbei ergibt sich eine feste mechanische, spielfreie Verbindung zwischen dem Gehäusematerial und dem Befestigungsstreifen 3. Um die Verankerung des Befestigungsstreifens 3 in dem Gehäuse 2 zu verbessern, kann der Befestigungsstreifen 3, z.B. mäanderförmig, gebogen ausgebildet sein. Ebenso können Verdickungen und/oder Materialschwächungen vorgesehen sein, so dass sich eine formschlüssige Verbindung zwischen dem Material des Gehäuses 2 und dem Befestigungsstreifen 3 ergibt (nicht dargestellt).

Wie aus der Querschnittsdarstellung der Figur ersichtlich ist, ist der Befestigungsstreifen 3 an der Unterseite des Gehäuses 2 angeordnet. Mit dem Begriff Unterseite wird vorliegend die der Anbaufläche 4 zugewandte Seite des elektrischen Geräts 1 verstanden. Der Befestigungsstreifen 3 kann sich hierbei über die gesamte Fläche der Gehäuseunterseite erstrecken. Zweckmäßigerweise ragt der Befestigungsstreifen 3 seitlich, d.h. in einer Richtung senkrecht zur Blattebene, nicht über die Umrandungen des Gehäuses 2 hinaus, wodurch ein besonders platzsparendes elektrisches Gerät geschaffen ist.

An dem ersten Ende 5 weist der Befestigungsstreifen 3 eine gebogene Befestigungslasche 17 auf. Diese ist durch die korrespondierende erste Aussparung 7 der Anbaufläche 4 teilweise geführt. Ein Teil der Befestigungslasche 3 liegt damit auf einer dem Gehäuse 2 gegenüber liegenden Seite der Anbaufläche 4. Ein anderer Teil der Befestigungslasche 3 ist auf der Seite des Gehäuses 2 der Anbaufläche 4 angeordnet.

An dem zweiten Ende 6 ist der Befestigungsstreifen 3 mit einem Mittelabschnitt 15 durch die korrespondierende zweite Aussparung 8 der Anbaufläche geführt. Der Mittelabschnitt 15 ist hierbei auf der dem Gehäuse 2 gegenüberliegenden Seite der Anbaufläche angeordnet. Aufgrund seiner Formgebung ist der Mittelabschnitt formschlüssig mit der Anbaufläche 4, insbesondere mit den Rändern der zweiten Aussparung 8, verbunden. Der Formschluss ist dadurch bewirkt, dass der Mittelabschnitt 15 eine größere Breite b1 aufweist, als die zweite Aussparung der Anbaufläche 4, welche eine Breite b2 aufweist.

Dies gilt dann, wenn sich das zweite Ende 6 des Befestigungsstreifens 3 in der gezeigten Stellung befindet und nicht mit einer externen Kraft beaufschlagt ist.

Eine solche externe Kraft kann an einem Endabschnitt 16 des zweiten Endes 6 des Befestigungsstreifens 3 von der Seite des Gehäuses 2 her aufgebracht werden. Wird der Endabschnitt 16, z.B. mit einem Schraubenzieher, in Richtung des Gehäuses 2 gedrückt, so kann die Breite b1 des Mittelabschnitts 15 gleich oder kleiner der Breite b2 der zweiten Aussparung 8 gemacht werden, so dass eine Demontage des elektrischen Gerätes 1 von der Anbaufläche 4 möglich ist. Dabei vollzieht das elektrische Gerät 1 eine Kipp- bzw. Drehbewegung um die in der ersten Aussparung 7 befindliche Befestigungslasche 17. Ist ein ausreichend großer Winkel erreicht, so kann der durch die erste Aussparung 7 hindurchgesteckte Abschnitt aus der ersten Aussparung 7 herausgezogen werden.

Die Montage erfolgt in umgekehrter Reihenfolge, indem zunächst das erste Ende 5 des Befestigungsstreifens 3 durch die erste Aussparung 7 gesteckt wird. Anschießend erfolgt eine Drehung des elektrischen Geräts 1 in Richtung der Anbaufläche 4. Hierbei wird der Mittelabschnitt 15 des Befestigungsstreifens 3 mit zunehmendem Eindringen in die zweite Aussparung 8 - entweder allein durch die Drehbewegung oder mit Unterstützung einer externen Kraft - deformiert, bis der kuppelförmige Abschnitt 18 des Mittelabschnitts 15 die zweite Aussparung 8 passiert hat. Aufgrund einer reversiblen Deformierbarkeit des Befestigungsstreifens 3 wird eine Rückstellkraft erzeugt, so dass sich die Breite b1 des Mittelabschnitts vergrößert, bis schließlich der Endabschnitt 16 am Rand der zweiten Aussparung 8 zum Liegen kommt, wie dies in der Figur dargestellt ist.

Die Elastizität und die durch den Befestigungsstreifen 3 ausgeübte Spannung können einerseits durch das Material des Befestigungsstreifens 3, dessen Dicke d sowie die Biegeradien festgelegt werden. Ferner kann die Elastizität durch Einschnürungen oder Materialschwächungen oder durch Materialverdickungen in entsprechenden Bereichen des Befestigungsstreifens 3 hervorgerufen werden.

Die spielfreie Befestigung des elektrischen Geräts 1 erfolgt ausschließlich durch die von dem Befestigungsstreifen 3 aufgebrachten Kräfte, wenn das erste und das zweite Ende 5, 6 in der in der Figur dargestellten Weise durch die korrespondierenden Aussparungen 7, 8 geführt sind. Die Montage des elektrischen Gerätes 1 an der Anbaufläche 4 kann, wie beschrieben, ohne spezielles Werkzeug auf einfache und schnelle Weise durchgeführt werden.

Durch das Vorsehen eines Vorsprunges 9 an der Gehäuseunterseite des Gehäuses 2, welche durch eine dritte Aussparung 14 der Anbaufläche 4 ragt, wenn das elektrische Gerät auf die Anbaufläche 4 aufgebracht ist, kann einerseits sichergestellt werden, dass ein bestimmtes elektrisches Gerät 1 an einer dafür vorgesehenen Stelle der Anbaufläche 4 montiert wird. Weist das elektrische Gerät 1 den Vorsprung 9 an einer anderen Stelle auf, so wäre eine Montage nicht möglich. Darüber hinaus trägt der Vorsprung 9 mit der dazu korrespondierenden Aussparung 14 dazu bei, das elektrische Gerät in einer Ebene parallel zu der Anbaufläche 4 sicher zu fixieren.

Das in der Figur gezeigte Ausführungsbeispiel stellt die Befestigung des elektrischen Gerätes 1 an der Anbaufläche 4 durch ein Scharnier (vgl. das erste Ende 5 in Verbindung mit der ersten Aussparung 7) sowie eine Schnappverbindung (vgl. das zweite Ende 6 in Verbindung mit der zweiten Aussparung 8) sicher. In einer alternativen Ausgestaltung könnte die Verbindung auch durch zwei Schnappverbindungen realisiert sein. Hierzu könnte an dem ersten Ende 5 des Befestigungsstreifens 3 eine dem zweiten Ende 6 entsprechende geometrische Ausgestaltung vorgesehen sein.

Die Ausgestaltung des Befestigungsstreifens 3 ist in der Figur lediglich beispielhafter Natur. Zur sicheren Fixierung des elektrischen Geräts 1 an der Anbaufläche 4 könnten auch davon abweichende Querschnittsgestaltungen vorgesehen sein, welche auch dem Erfindungsgedanken entsprechen.

Ein erfindungsgemäßes elektrisches Gerät ermöglicht dessen Befestigung an einer Anbaufläche unter Verzicht auf Schraub-oder Nietverbindungen. Hierdurch können die Kosten für die Herstellung des elektrischen Geräts sowie für dessen Montage an der Anbaufläche gesenkt werden. Darüber hinaus ist ein geringerer Flächenbedarf im Vergleich zum Stand der Technik notwendig.

## Patentansprüche

1. Elektrisches Gerät (1) für ein Kraftfahrzeug, insbesondere Airbag-Sensor, mit einem Gehäuse (2) zur Aufnahme eines Sensors und mit einem Befestigungsmittel zur Befestigung des Geräts (1) an einer Anbaufläche (4) des Kraftfahrzeugs, bei dem das Befestigungsmittel einen Befestigungsstreifen (3) umfasst, der teilweise in das Gehäuse (2) des elektrischen Geräts (1) eingelassen und mit seinen gegenüberliegenden Enden (5, 6) mit korrespondierenden Aussparungen (7, 8) der Anbaufläche (4) des Kraftfahrzeugs formschlüssig verbunden ist.

2. Gerät nach Anspruch 1, bei dem das Gehäuse (2) aus einem Kunststoff gebildet ist.

3. Gerät nach Anspruch 1 oder 2, bei dem der Befestigungsstreifen (3) aus Metall gebildet ist.

4. Gerät nach Anspruch 2 oder 3, bei dem der Befestigungsstreifen (3) von dem Gehäusematerial umspritzt ist.

5. Gerät nach einem der vorherigen Ansprüche, bei dem dessen Befestigung allein durch die Form des Befestigungsstreifens (3) bewirkbar ist.

6. Gerät nach einem der vorherigen Ansprüche, bei dem die Dicke (d) des Befestigungsstreifens (3) über dessen gesamte Länge gleich ist.

7. Gerät nach einem der vorherigen Ansprüche, bei dem der Befestigungsstreifen (3) Abschnitte unterschiedlicher Elastizität aufweist.

8. Gerät nach einem der vorherigen Ansprüche, bei dem der Befestigungsstreifen (3) zumindest teilweise Einschnürungen oder Materialschwächungen aufweist.

9. Gerät nach einem der vorherigen Ansprüche, bei dem der Befestigungsstreifen (3) zumindest teilweise Materialverdickungen aufweist.

10. Gerät nach einem der vorherigen Ansprüche, bei dem der Formschluss mit der Anbaufläche (4) über zwei Schnappverbindungen herstellbar ist.

11. Gerät nach einem der Ansprüche 1 bis 9, bei dem der Formschluss mit der Anbaufläche (4) über eine Schnappverbindung und ein Scharnier herstellbar ist.

12. Gerät nach einem der Ansprüche 1 bis 9, bei dem der Befestigungsstreifen (3) an einem ersten Ende (5) eine gebogene Befestigungslasche (17) aufweist, die dazu geeignet ist, durch eine korrespondierende erste Aussparung (7) der Anbaufläche (4) geführt zu werden, wenn das elektrische Gerät (1) auf die Anbaufläche (4) aufgebracht ist, so dass ein Teil der Befestigungslasche (17) auf einer dem Gehäuse (2) gegenüberliegenden Seite der Anbaufläche (4) und ein anderer Teil auf der Seite des Gehäuses (2) der Anbaufläche (4) angeordnet ist.

13. Gerät nach Anspruch 12, bei dem der Befestigungsstreifen (3) an einem zweiten Ende (6) dazu ausgebildet ist, mit einem Mittelabschnitt (15) durch eine korrespondierende zweite Aussparung (8) der Anbaufläche (4) geführt zu werden, wenn das elektrische Gerät (1) auf die Anbaufläche (4) aufgebracht ist, so dass der Mittelabschnitt (15) auf einer dem Gehäuse (2) gegenüberliegenden Seite der Anbaufläche (4) angeordnet und formschlüssig mit der Anbaufläche (4) verbunden ist.

14. Gerät nach Anspruch 13, bei dem der Mittelabschnitt (15) in einer Erstreckungsrichtung eine größere Breite (b1) aufweist als die zweite Aussparung der Anbaufläche (4), wenn der Mittelabschnitt (15) nicht mit Kraft beaufschlagt ist.

15. Gerät nach Anspruch 13 oder 14, bei dem der Mittelabschnitt (15) unter Kraftaufbringung reversibel deformierbar ausgebildet ist.

16. Gerät nach einem der Ansprüche 13 bis 15, bei dem ein Endabschnitt (16) des zweiten Endes (6) des Befestigungsstreifens (3) von der Seite des Gehäuses (2) her betätigbar ist, wenn das elektrische Gerät (1) auf die Anbaufläche (4) aufgebracht ist oder wird.

17. Gerät nach einem der vorherigen Ansprüche, bei dem das Gehäuse (2) zumindest einen Vorsprung (14) aufweist, welcher in eine dritte Aussparung (9) der Anbaufläche (4) ragt, wenn das elektrische Gerät (1) auf die Anbaufläche (4) aufgebracht ist.

18. Gerät nach einem der vorherigen Ansprüche, bei dem der Sensor ein Crash-Sensor ist, insbesondere ein Beschleunigungssensor, ein Körperschallsensor oder ein Drucksensor.
